# FASCICULE DE BREVET EUROPEEN

(11) **EP 2 730 980 B1**
(45) Date de publication et mention de la délivrance du brevet: **29.08.2018**
(21) Numéro de dépôt: 12192026.8
(22) Date de dépôt: 09.11.2012
(51) Int. Cl.: G04B 17/26, G04B 15/14

(54) **Mécanisme horloger de limitation ou transmission**
Uhrmechanismus zur Begrenzung oder Übertragung
Clockwork limitation or transmission mechanism

(43) Date de publication de la demande: 14.05.2014
(73) Titulaire: Nivarox-FAR S.A., 2400 Le Locle (CH)
(72) Inventeur: Stranczl, Marc, 1260 Nyon (CH); Hessler, Thierry, 2024 St-Aubin (CH)
(74) Mandataire: Giraud, Eric

(56) Documents cités:
- EP-A1- 1 710 636
- EP-A1- 2 407 831
- EP-A1- 2 431 823
- EP-A1- 2 450 756
- EP-A1- 2 450 757
- EP-A2- 2 037 335
- WO-A1-2007/000271
- WO-A1-2011/120180
- WO-A1-2013/144236
- CH-A2- 703 333
- FR-A1- 2 258 656

## Description

### Domaine de l'invention

L'invention concerne un mécanisme anti-galop pour limiter le débattement angulaire d'un balancier d'horlogerie d'un mouvement d'horlogerie, lequel balancier comporte un arbre et une cheville saillante dudit arbre, ledit mécanisme anti-galop comportant au moins un élément flexible bistable qui est agencé pour être fixé, par l'intermédiaire d'éléments de liaison flexibles et élastiques que comporte ledit mécanisme, à un élément rigide de structure dudit mouvement d'horlogerie, et lequel élément flexible bistable est porteur d'au moins une butée anti-galop qui comporte deux bras, dont les extrémités respectives peuvent chacune venir en interférence avec la trajectoire de ladite cheville

L'invention concerne encore un mouvement d'horlogerie comportant au moins un organe régulateur à balancier, et qui comporte au moins un tel mécanisme horloger de limitation ou transmission.

L'invention concerne encore une pièce d'horlogerie ou montre, comportant au moins un tel mouvement ou au moins un tel mécanisme horloger de limitation ou transmission.

L'invention concerne le domaine des mécanismes d'échappement d'horlogerie.

### Arrière-plan de l'invention

L'amélioration de la marche et la recherche d'un meilleur rendement sont des préoccupations constantes des constructeurs de montres mécaniques, qui cherchent à obtenir la plus grande réserve de marche possible, conjuguée avec régularité, précision, et sécurité dans les conditions d'utilisation les plus dures.. L'ensemble réglant, et le mécanisme d'échappement sont au coeur de cette problématique.

En particulier, dans les montres mécaniques, les échappements doivent répondre à plusieurs critères dits de sécurité. Une des sécurités, le mécanisme anti-galop, vise à empêcher l'extension angulaire du balancier au-delà d'un angle normal de rotation.

Le brevet EP 1 801 668 B1 au nom de Montres Breguet SA propose un mécanisme dont la structure est caractéristique en ce qu'il comprend un pignon monté sur l'arbre du balancier. Ce pignon engrène une roue dentée dont au moins un rayon vient buter contre un arrêt fixe si le balancier est entrainé au-delà de son angle normal de rotation. Ce mécanisme influence l'inertie du balancier et perturbe ainsi ses oscillations. De plus, l'engrenage qui le compose présente des frottements qui perturbent également le mécanisme de régulation.

Le document EP 1 666 990 A2 au nom de Montres Breguet SA expose un autre mécanisme anti-galop basé sur l'expansion du spiral: un bras de blocage, fixé sur la spire extérieure du spiral, s'interpose entre un doigt solidaire du balancier et deux colonnes solidaires du pont du balancier. Ce blocage a lieu uniquement en cas d'expansion excessive du spiral au-delà d'un angle dépassant son angle de fonctionnement normal. Ce mécanisme limite l'angle de rotation uniquement dans un sens de rotation.

Le document EP 2 450 756 A1 NIVAROX décrit un dispositif anti-galop pour mécanisme d'échappement, avec un mobile pivotant porteur d'un doigt lequel circule dans une piste de came solidaire du balancier. Ce mobile pivotant peut comporter un bras avec une bascule bistable, notamment une lame élastique bistable.

Le document EP 2 037 335 A2 ENZLER-VON GUNTEN décrit une ancre qui comporte deux bras munis de palettes, et une fourchette d'ancre, l'ensemble étant réalisé de façon monobloc avec deux lames flexibles de fixation, qui définissent un axe virtuel de pivotement de l'ancre, et qui autorisent le pivotement de l'ancre lors de leur flexion, les axes médians de ces deux lames se coupant au niveau de cet axe virtuel.

Le document WO2011/120 180A1 au nom de ROLEX décrit un dispositif de blocage de roue d'échappement avec un bloquer à deux palettes relié par deux éléments élastiques à un châssis pour définir un pivot virtuel, et au moins un troisième élément élastique agissant latéralement sur le bloqueur.

Le document CH 703 333 A2 au nom de FRAGNIERE décrit une ancre avec un ressort de rappel bistable fixé sur la baguette de l'ancre entre la fourchette et l'axe de pivotement.

Le document WO 2013/144236 au nom de NIVAROX décrit un mécanisme d'échappement flexible à cadre mobile porté par des lames flexibles bistables.

Le document EP 1 710 636 A1 au nom de ROCHAT décrit un mécanisme d'échappement avec un plateau de balancier comportant une cheville et une palette d'impulsion coopérant avec une roue d'échappement. Il comporte un organe de limitation avec un mouvement périodique où il coopère avec la cheville pour limiter la course du plateau. Il comporte encore un organe de commande avec une levée de repos, qui accomplit un mouvement périodique au cours duquel la roue d'échappement est libérée, et donne une impulsion à la palette d'impulsion. Les périodes des organes de limitation et de commande correspondent respectivement à une alternance et à une oscillation du balancier.

Le document EP 2 450 757 A1 au nom de NIVAROX décrit un dispositif anti-galop pour mécanisme d'échappement, coopérant avec un balancier, et qui comporte une cheville de limitation fixée à une platine, et un ensemble bistable mobile lequel comporte, d'une part un rotor agencé fixé sur ce balancier et pivotant synchrone avec lui, et d'autre part une bascule bistable mobile en pivotement par rapport à ce rotor autour d'un axe de pivotement déporté, sur un secteur angulaire limité entre deux positions d'indexation que peuvent occuper des moyens d'indexation de cet ensemble bistable pour mémoriser l'état du balancier. Une partie de la trajectoire de la bascule bistable, lors du pivotement du balancier, est interférente avec la cheville. L'ensemble bistable comporte encore des moyens de limitation d'amplitude pour limiter l'amplitude du pivotement angulaire du balancier en cas de choc.

En somme, les mécanismes de sécurité connus présentent, chacun, au moins un des inconvénients récurrents : la perturbation des oscillations par modification de l'inertie de l'organe régulateur, la dégradation du rendement sous l'effet de frottement, la limitation de l'angle de rotation dans un sens de rotation seulement.

### Résumé de l'invention

La présente invention vise à améliorer le rendement d'une montre, et à résoudre les problèmes cités plus haut, en ne perturbant que très faiblement les oscillations du balancier, avec une perte de rendement négligeable ou nulle, et en limitant la course angulaire du balancier dans les deux sens de rotation.

Le mécanisme anti-galop selon l'invention se base sur un principe de mémorisation de la position du balancier analogue à celui de l'ancre suisse : un élément change de position au passage du balancier et positionne une butée anti-galop, comme le font, dans le cas de l'ancre suisse, les goupilles de limitation d'entrée et sortie ou étoqueaux via la fourchette et ses cornes.

A cet effet, l'invention concerne un mécanisme anti-galop selon la revendication 1.

L'invention concerne encore un mouvement d'horlogerie selon la revendication 10.

L'invention concerne encore une pièce d'horlogerie ou montre, comportant au moins un tel mouvement ou au moins un tel mécanisme anti-galop.

### Description sommaire des dessins

D'autres caractéristiques et avantages de l'invention apparaîtront à la lecture de la description détaillée qui va suivre, en référence aux dessins annexés, où :
- la figure 1 représente, de façon schématisée et en vue de face, un mécanisme horloger de limitation ou transmission réalisé sous la forme d'un mécanisme anti-galop, fixé à une structure d'un mouvement et coopérant alternativement avec l'un de plusieurs bras qu'il comporte, deux dans cette illustration, avec une cheville d'un balancier ;
- la figure 2 représente, de façon similaire à la figure 1, le même mécanisme complété par un mécanisme antichocs ;
- la figure 3 représente, de façon schématisée, trois états d'une poutre encastrée : au repos en 3A, dans un premier mode de flambage en 3B, dans un deuxième mode de flambage en 3C ;
- la figure 4 représente, de façon schématisée et en vue de face, une poutre encastrée précontrainte en flambage dans le deuxième mode de la figure 3A sous l'action d'un pivot flexible ;
- la figure 5 représente, de façon schématisée et en vue de face, une réalisation de l'invention selon le principe de la figure 4, avec une précontrainte par vis excentrées de la poutre en flambage, et dans une exécution monobloc ;
- la figure 6 illustre une variante de la figure 5 et où la précontrainte est réalisée par des poches d'oxyde de silicium dans un bâti en silicium ; les figures 6A et 6B illustrent, avant et après oxydation du silicium, un détail d'une zone comportant de fortes différences de section, et fortement modifiée après formation de dioxyde de silicium, et soumettant à un effort en flambage une poutre droite de section moindre ;
- la figure 7 illustre un autre principe de précontrainte par différentiel de résistance au flambage entre un réseau de poutres parallèles en silicium oxydé et une poutre seule ainsi précontrainte en flambage ; les figures 7A, 7B, 7C, illustrent des étapes successives d'un procédé d'oxydation et de mise en flambage d'une poutre ;
- la figure 8 illustre une variante avec des bras de butée anti-galop comportant des zones flexibles d'amortissement de chocs ;
   - la figure 9 représente, de façon schématisée et partielle, une pièce d'horlogerie sous la forme d'une montre comportant un mouvement avec un dispositif anti-galop selon l'invention ;
   - la figure 10 illustre une configuration dans laquelle un pivot virtuel bistable du mécanisme anti-galop est mobile en translation ;
   - la figure 11 illustre un détail d'un mécanisme anti-galop comportant au moins deux niveaux pour assurer le maintien des bras du système anti-galop dans le plan de la cheville de balancier : un premier niveau supérieur avec des bras coopérant avec cette cheville, et un deuxième niveau inférieur avec un dard coopérant avec une encoche de balancier ;
   - la figure 12 est une structure déformable par oxydation du silicium, en variante de celle de la figure 7A ;
   - la figure 13 représente la section d'une structure en quartz monocristallin, pour la réalisation d'un mécanisme anti-galop selon l'invention ;
   - la figure 14 illustre un mécanisme, avec une fonction de répulsion, entre la cheville de balancier et les bras du mécanisme anti-galop, est remplie par des aimants situés dans une orientation verticale, et avec une coupe selon la ligne en trait interrompu ;
   - la figure 15 illustre une réalisation analogue, avec une orientation dans le plan du champ magnétique ;
   - la figure 16 schématise, de façon analogue à la figure 10, un cas plus général où le mouvement est quelconque, et bistable ;
   - les figures 17A et 17B illustrent l'obtention de la précontrainte par rencontre des croissances d'oxyde (avant et après) dans un serpentin.
   - les figures 18A et 18B (et leurs détails en figures 19A et 19B) montrent l'obtention de la précontrainte par l'ouverture des angles au sommet d'un profilé en zig-zag lors de la croissance de l'oxyde de silicium(avant et après) ;
- les figures 20A et 20B illustrent une variation d'angle obtenue par la variation (avant et après) du rayon de courbure des parois oxydées dans une zone à très faible rayon de courbure ;
- la figure 21 montre schématiquement une lame flexible bistable coopérant avec les deux extrémités d'une masse unique ;

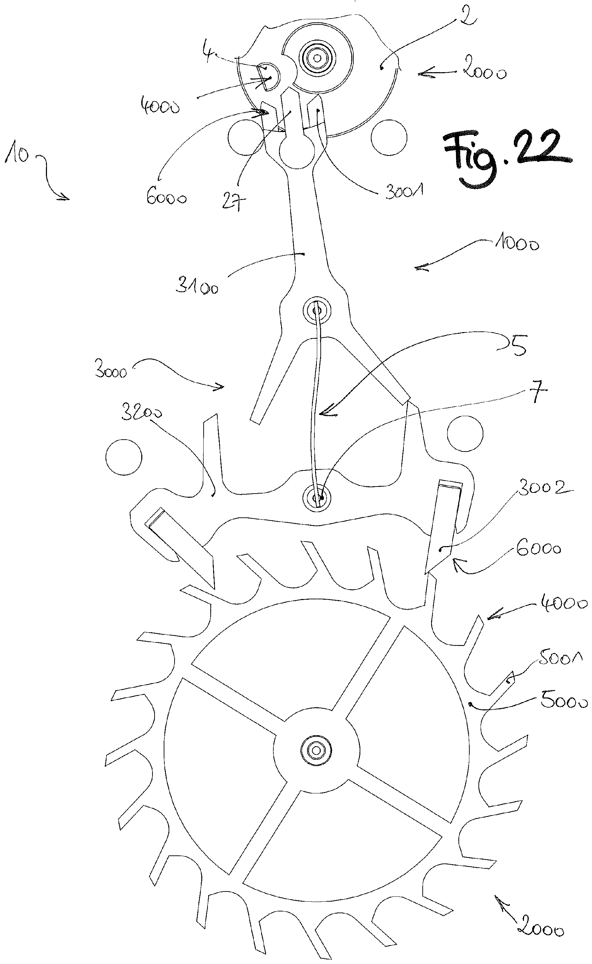

- la figure 22 illustre en vue en plan une autre application où le mécanisme horloger de limitation ou transmission est un mécanisme d'ancre entre un balancier et une roue d'échappement.

### Description détaillée des modes de réalisation préférés

L'invention concerne un mécanisme horloger de limitation ou transmission 1000 pour limiter ou transmettre le débattement angulaire d'un mobile 2000 d'un mouvement d'horlogerie 10, ce mobile 2000 comportant au moins une cheville ou dent 4000 saillante, notamment radialement dans le cas d'une dent 5001, ou axialement dans le cas d'une cheville 4. Ce mécanisme horloger de limitation ou transmission 1000 comporte des moyens de limitation ou de transmission 6000) qui sont fixés, par l'intermédiaire au moins un élément flexible multistable, notamment bistable, 5, à un autre composant du mouvement 10 ou à un élément rigide de structure 7 du mouvement 10.

Dans une application particulière, ce mécanisme horloger de limitation ou transmission 1000 est un mécanisme anti-galop 1, qui est destiné à empêcher l'emballement d'un balancier d'horlogerie 2, lequel comporte un arbre 3 et une cheville 4 ou un élément similaire saillant de cet arbre 3.

Le mécanisme anti-galop 1 comporte au moins un élément monolithique bistable flexible, qu'on dénommera ci-après élément flexible bistable 5, porteur d'au moins une butée anti-galop 6, et qui est fixé, par l'intermédiaire d'éléments de liaison flexibles et élastiques, à un élément rigide de structure 7, tel que platine, pont, ou similaire, d'un mouvement d'horlogerie 10 dans lequel est intégré un organe régulateur auquel appartient le balancier 2.

Dans une variante particulière, cette structure 7 contient un système d'auto-alignement avec l'axe du balancier 2.

Cet élément flexible bistable 5 est porteur d'au moins une butée anti-galop 6, dont une extrémité 63 ou 64 peut, selon la position angulaire du balancier 2, venir en interférence avec la trajectoire de la cheville 4, et remplir la fonction de butée si le balancier 2 dépasse sa course angulaire normale.

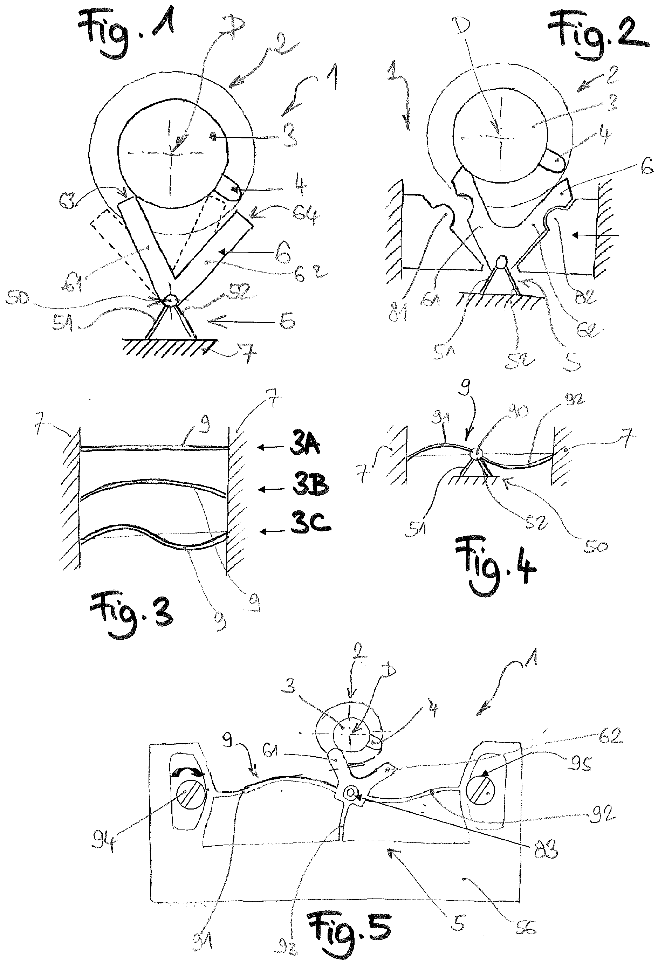

La figure 1 expose le schéma de principe, dans une application particulière, préférée mais non limitative, où l'élément flexible bistable 5 et la au moins une butée anti-galop 6 forment ensemble un composant monolithique. Dans cet exemple nullement limitatif, la butée anti-galop 6 comporte deux bras 61, 62, dont les extrémités respectives 63, 64, peuvent chacune, selon la position du balancier 2, venir en interférence avec la trajectoire de la cheville 4, et remplir la fonction de butée si le balancier 2 dépasse sa course angulaire normale. Cette réalisation à deux bras, telle qu'illustrée, assure la limitation de l'angle de rotation du balancier 2 dans les deux sens de rotation de ce dernier. La figure 1 montre, en trait interrompu, une position d'interférence avec le balancier 2, assurant la limitation de son débattement angulaire.

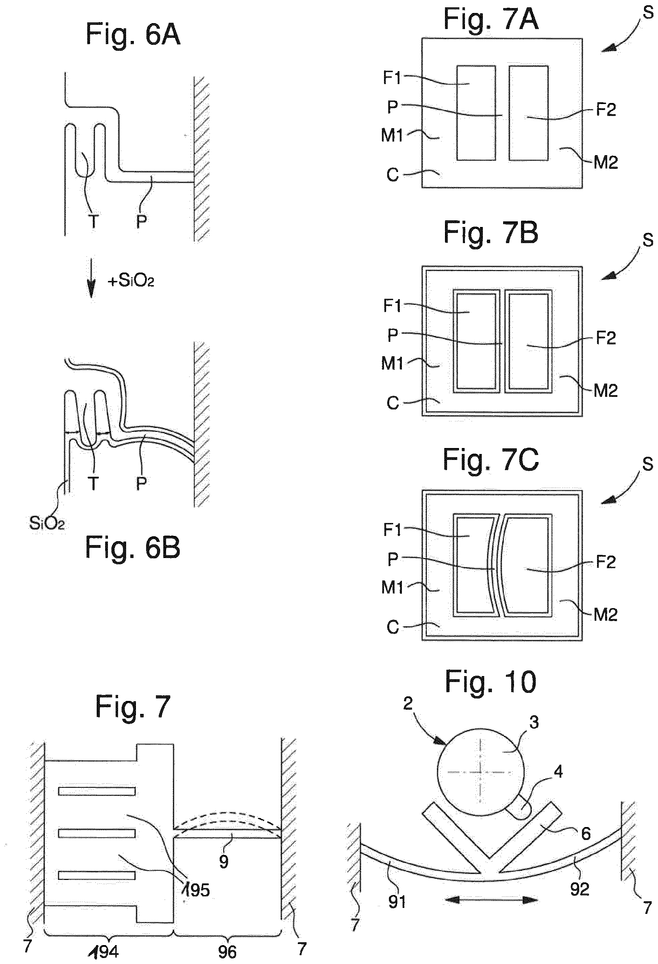

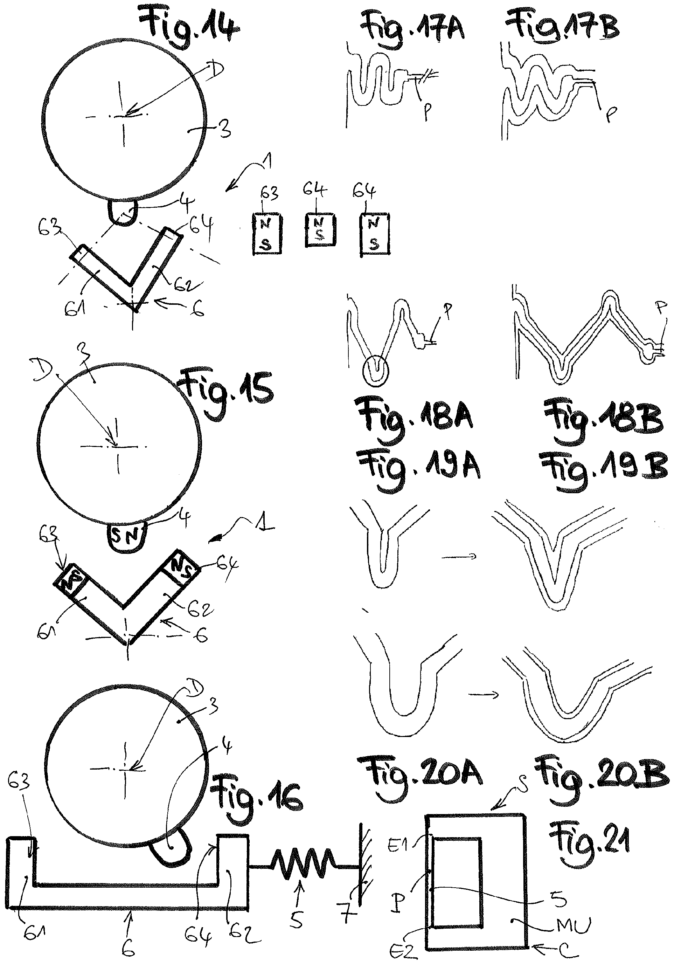

L'élément flexible bistable 5 est ici illustré avec ces éléments de liaison flexibles et élastiques qui sont constitués par au moins deux lames fines 51, 52, chacune fixée à une première extrémité à la structure 7, et reliées par une deuxième extrémité au corps de l'élément flexible. Dans le cas particulier de la figure 1, les deux lames fines 51, 52, sont reliées par leurs deuxièmes extrémités au corps de l'élément flexible en formant un vé, de façon à définir un pivot fictif 50 autour duquel peut pivoter la butée anti-galop 6. Ainsi, dans le cas des figures 1 et 2, l'élément flexible bistable 5 est un pivot flexible bistable. Ce mode de réalisation n'est pas exclusif, la figure 10 schématise le cas où la butée anti-galop 6 est mobile en translation. La figure 16 illustre un cas plus général où le mouvement est quelconque, et bistable.

De préférence, au moins deux lames flexibles 51, 91, 52, 92, sont montées précontraintes en flambage par rapport à la structure 7 ou par rapport à un bâti 56 que comporte l'élément flexible bistable 5.

Chacune des lames 51, 52 peut occuper plusieurs états, selon les efforts auxquels elle est soumise. Chacune de ces lames est calculée pour travailler en flambage, et peut adopter plusieurs géométries, selon son mode de flambage, tel que visible sur la figure 3 : au repos en 3A, en premier mode de flambage, avec une forme concave ou convexe en 3B, en deuxième mode de flambage avec une forme en S ou Z en 3C. L'élément flexible bistable 5 peut comporter des éléments flexibles avec d'autres formes que ces lames flexibles 51, 52, illustrées ici, sans s'éloigner de l'invention.

L'élément flexible bistable 5 peut, encore, dans une réalisation particulière, être réalisé monobloc avec l'élément de structure 7.

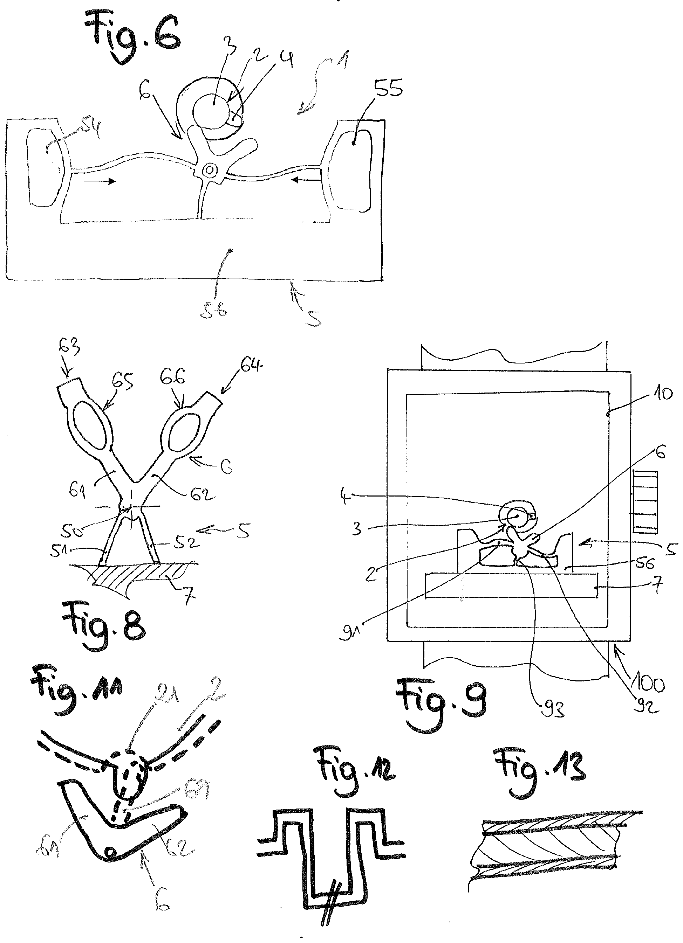

Dans une réalisation particulière, illustrée à la figure 8, des éléments flexibles 65, 66, peuvent être inclus aux bras 61, 62, de la butée 6 du mécanisme anti-galop 1, afin d'éviter des chocs trop importants.

Un tel élément flexible bistable 5 peut être réalisé par technologie silicium, « LIGA », MEMS, ou similaire. Son inertie est très faible comparée à celle du balancier 2, et son actionnement perturbe faiblement les oscillations du balancier 2.

La figure 2 illustre un mécanisme antichoc de protection des lames flexibles 51 et 52 de l'élément flexible bistable 5. Il est utile, voire nécessaire, dans les cas où les butées anti-galop 6 doivent limiter l'amplitude du balancier 2. Le but est d'absorber les chocs dans des butées antichocs 81, 82, qui coopèrent en appui de butée avec les bras 61, 62, et de ne pas transmettre ces chocs dans les lames flexibles 51, 52 afin d'éviter une rupture de celles-ci. La figure 5 présente une butée antichocs 83 coaxiale avec le pivot flexible. Dans cet exemple de réalisation les butées antichocs 81 et 82 comportent des saillantes sensiblement cylindriques, qui coopèrent avec des rainures de forme sensiblement complémentaire sur les bras 61 et 62.

Le pivot bistable flexible 5 peut être réalisé selon plusieurs principes. La figure 3 introduit un principe d'état bistable étudié dans ce cas particulier. On utilise les modes naturels de flambage d'une poutre 9 soumise à une contrainte, plus particulièrement le deuxième mode illustré en 3C.

Tel que visible sur la figure 4, dans une réalisation avantageuse, afin de contraindre la poutre 9 à flamber selon le deuxième mode, un pivot 90 oblige la poutre 9 à avoir un noeud en son milieu (centre de rotation du pivot ajouté). Le centre de rotation 50 du pivot bistable 5 correspond alors au centre de rotation du pivot 90 ajouté.

La figure 5 expose un mécanisme anti-galop 1 complet réalisé selon ce principe. Le pivot bistable flexible 5 comporte au moins une poutre 9 précontrainte en flambage selon un deuxième mode où la poutre 9 adopte une forme en S ou en Z, un pivot 90 obligeant cette poutre 9 à avoir un noeud en zone médiane, de préférence en son milieu. Selon l'invention, illustrée à la figure 5, le pivot bistable flexible 5 est réalisé par flambage de deux poutres 91 et 92 précontraintes (qui composent ensemble la poutre 9) en les contraignant ici via deux vis excentrées 94 et 95. Une troisième poutre 93, fixée à la structure 7 ou à un bâti 56 de l'élément flexible bistable 5, force la poutre 9 composée des poutres 91 et 92 à se déformer dans le deuxième mode, et joue le rôle du pivot 90 de la figure 4. La butée antichoc 83 est située dans le centre de rotation 50 du pivot bistable flexible 5.

La figure 11 illustre une butée anti-galop 6 comportant au moins deux niveaux pour assurer le maintien des bras 61, 62, du système anti-galop dans le plan de la cheville 4 de balancier : un premier niveau supérieur avec des bras 61 et 62 coopérant avec cette cheville 4, et un deuxième niveau inférieur avec un dard 67 coopérant avec une encoche 21 du balancier 3.

Pour supprimer les contacts ou du moins diminuer les pressions de contact, le mécanisme anti-galop 1 selon l'invention peut encore avantageusement comporter des moyens pour créer une force ou un couple de répulsion entre le balancier 2 et les bras 61, 62, du mécanisme anti-galop 1.

La figure 14 illustre le cas où cette fonction de répulsion est remplie par des aimants situés dans une orientation verticale, au niveau de la cheville 4 et des extrémités 63, 64, des bras 61, 62. La figure 15 illustre une réalisation analogue, avec une orientation dans le plan du champ magnétique, on voit les pôles nord et sud de ces aimants.

Dans une localisation similaire, on peut avantageusement utiliser, à la place des aimants, ou en plus de ceux-ci, des électrets (charges électrostatiques) pour exercer de telles forces de répulsion.

Il s'agit d'augmenter le rendement du mécanisme anti-galop 1, et de perturber le moins possible la marche du balancier 2. Le fonctionnement du mécanisme anti-galop 1 est le suivant :
- lors du basculement, dans une première phase, le balancier 2 fournit de l'énergie à l'élément flexible bistable 5 ;
- une fois passé le point d'équilibre, dans une deuxième phase, le mécanisme restitue une partie de l'énergie au balancier 2 en faisant une petite impulsion.

Le mécanisme fonctionne de manière analogue aux cornes d'une ancre suisse, il y a un dégagement puis une impulsion.

Dans une réalisation particulière, le balancier 2, ou/et au moins les bras 61, 62, de la butée anti-galop 6, voire le mécanisme anti-galop 1 complet quand il est monobloc, dans une réalisation avantageuse, est réalisé en technologie silicium à partir d'un wafer silicium, avec ou sans croissance d'oxyde de silicium, et avec une couche superficielle renfermant, selon le cas, ou bien des aimants ou des particules magnétiques d'une part, ou bien des électrets d'autre part. Cette couche particulière peut être réalisée par un procédé galvanique, ou par pulvérisation cathodique, ou par un autre procédé microtechnique de structuration adéquat.

Dans le cas préféré d'une élaboration de l'élément flexible bistable 5 en technologie silicium, la création de contraintes dans les lames constituant les poutres 91 et 92 peut se faire par oxydation du silicium. En effet, l'oxyde de silicium prend un plus grand volume lors de sa croissance à partir du silicium, tel que visible sur la figure 6, où des poches 54, 55, de SiO2, sont créées dans un bâti 56 en silicium. On voit sur cet exemple de la figure 5 ou 6, que ce bâti 56 peut aussi constituer la structure 7, ou encore y être relié de façon très simple par toute technologie usuelle de fixation mécanique.

Les figures 6A et 6B illustrent, avant et après oxydation du silicium, un détail d'une zone comportant de fortes différences de section, et fortement modifiée après formation de dioxyde de silicium, et soumettant à un effort en flambage une poutre droite P de section moindre qu'une tête T dont elle constitue un prolongement.

Un autre moyen de réaliser les contraintes de flambage dans ces lames est l'oxydation d'une structure en silicium, de forme particulière, exposée à la figure 7. L'oxydation du silicium induit des contraintes en surface qui ont pour effet d'allonger la longueur d'une poutre oxydée. La figure 7 illustre un autre principe de précontrainte par différentiel de résistance au flambage entre un réseau de poutres parallèles en silicium oxydé et une poutre seule ainsi précontrainte en flambage, et présente un mécanisme simple où, en partie gauche, une structure parallèle 94 comporte un faisceau de poutres parallèles 95 qui vont, après oxydation (en trait interrompu), contraindre en fléchissement en flambage, en partie droite, un élément flexible à contraindre 96, en l'occurrence une poutre 9, 91, 92, ou similaire, dont on désire obtenir une déformation, la résistance au flambage de la structure parallèle 94 étant beaucoup plus grande que celle de l'élément flexible à contraindre 96. Les figures 7A, 7B, 7C, illustrent des étapes successives d'un procédé d'oxydation et de mise en flambage d'une poutre P, ménagée entre deux fenêtres F1, F2 d'un cadre C. La figure 7A montre la structure de base résultant de la mise en forme par gravure du silicium, au moment de sa mise dans un four. La figure 7B illustre le développement d'oxyde de silicium SiO₂, à l'intérieur des fenêtres F1 et F2 et donc sur les flancs de la poutre P, par maintien de la structure à 1100°C pendant plusieurs heures ; de façon connue, la croissance du dioxyde de silicium SiO₂ se fait par consommation partielle du silicium vers l'extérieur du composant, et de ce fait dans la mince poutre P la proportion de dioxyde de silicium SiO₂ augmente quand la proportion de silicium diminue, au fil du temps pendant ce traitement à 1100°C. La figure 7C montre la contraction de la structure après un refroidissement à la température ambiante, environ 20°C : les montants latéraux M1, M2 du cadre C, parallèles à la poutre P, qui sont essentiellement formés de silicium et d'un peu de dioxyde de silicium, se contractent davantage que la poutre P, qui est alors essentiellement formée de dioxyde de silicium qui a un coefficient de dilatation plus faible que le silicium.de ce fait la poutre P est soumise à un effort de flambage, et prend un état bistable.

Une autre variante est illustrée à la figure 12.
Les figures 17A et 17B illustrent aussi l'obtention de la précontrainte par rencontre des croissances d'oxyde dans un serpentin.
Les figures 18A et 18B (et leurs détails en figures 19A et 19B) montrent l'obtention de la précontrainte par l'ouverture des angles au sommet d'un profilé en zig-zag selon le même principe : la croissance de l'oxyde de silicium force l'ouverture de ces angles, et le déplacement est amplifié par la géométrie en Z ou en zig-zag de la structure. Les figures 20A et 20B montrent une variation d'angle obtenue par la variation du rayon de courbure des parois oxydées dans une zone à très faible rayon de courbure.

Suivent ci-après différentes variantes de procédé pour réaliser une lame flexible bistable.

Dans une première variante, illustrée par la figure 21, une lame flexible bistable 5 coopère avec les deux extrémités E1, E2, d'au moins une masse, et en particulier d'une masse unique MU. Le procédé comporte alors la succession des opérations suivantes :
- on grave un composant S en silicium dans lequel une poutre longiligne P de faible section fait la liaison entre deux extrémités E1, E2 d'au moins une masse MU, de forte section (au moins supérieure à dix fois cette faible section), cette au moins une masse MU constituant un cadre rigide C ;
- on soumet ce composant S, dans un four, à un procédé connu de croissance de dioxyde de silicium SiO₂ par maintien pendant plusieurs heures à une température de 1100°C ;
- on ajuste cette durée de plusieurs heures de façon à ce que un premier rapport RA entre la section de la poutre P formée de dioxyde de silicium SiO₂ et la section de la poutre P formée de silicium soit supérieur à 1 ; on peut d'ailleurs aller jusqu'à l'oxydation complète du silicium dans cette poutre P qui devient l'élément flexible 5. Un deuxième rapport RB entre la section de la masse MU formée de dioxyde de silicium SiO₂ et la section de la masse MU formée de silicium est très inférieur au premier rapport RA. Le ratio RA/RB est compris entre 2 et 10000, de préférence entre 10 et 1000, et, dans une application préférée, est supérieur à 100.

- on effectue un refroidissement à la température ambiante, environ 20°C, de façon à déformer en flambage la poutre P lors du refroidissement de la au moins une masse MU, dont la contraction lors de ce refroidissement est supérieure à la contraction de cette poutre P. Les figures 7A, 7B, 7C, illustrent une deuxième variante de mise en oeuvre d'un procédé de réalisation d'une lame flexible bistable, impliquant au moins deux masses. Ce procédé comporte la succession des opérations suivantes :
- on grave un composant S en silicium dans lequel une poutre longiligne P de faible section fait la liaison entre au moins deux masses M1, M2, chacune de forte section (au moins supérieure à dix fois cette faible section), ces deux masses M1, M2,constituant ensemble ou avec d'autres éléments de structure un cadre rigide C ;
- on soumet ce composant S, dans un four, à un procédé connu de croissance de dioxyde de silicium SiO₂ par maintien pendant plusieurs heures à une température de 1100°C ;
- on ajuste cette durée de plusieurs heures de façon à ce que le premier rapport RA entre la section de la poutre P formée de dioxyde de silicium SiO₂ et la section de la poutre P formée de silicium soit supérieur à 1 ; on peut d'ailleurs aller jusqu'à l'oxydation complète du silicium dans cette poutre P qui devient l'élément flexible 5. Un deuxième rapport RB entre la section de chacune des masses M1, M2, formée de dioxyde de silicium SiO₂ et la section de la masse correspondante formée de silicium est très inférieur au premier rapport RA. Le ratio RA/RB est compris entre 2 et 10000, de préférence entre 10 et 1000, et, dans une application préférée, est supérieur à 100.
- on effectue un refroidissement à la température ambiante, environ 20°C, de façon à déformer en flambage la poutre P lors du refroidissement des deux masses M1 et M2 dont la contraction lors de ce refroidissement est supérieure à la contraction de cette poutre P.

Dans une autre variante de réalisation, la structure du mécanisme anti-galop 1 est réalisée en quartz monocristallin. Tel que visible sur la figure 13, le noyau central en quartz monocristallin est revêtu sur ses faces supérieure et inférieure d'un dépôt réalisé à une température supérieure à la température ambiante, avec un coefficient α inférieur au coefficient α_{x,y} du quartz. Ce coefficient α_{x,y} du quartz est de 7,5 ppm/°C.

Le mécanisme anti-galop 1 illustré ici limite le sens de rotation du balancier dans les deux sens de rotation. Il ne perturbe que très faiblement les oscillations du balancier 2.

L'invention peut être utilisée dans les montres mécaniques ne présentant pas de mécanisme anti-galop.

Dans une autre application particulière, ce mécanisme horloger de limitation ou transmission 1000 est un mécanisme d'ancre 3000 pour mécanisme d'échappement, notamment mais non limitativement une ancre suisse, sur le même principe, pour sa coopération avec un balancier 2 et avec une roue d'échappement 5000. Une telle ancre 3000 comporte au moins un élément flexible 5 multistable, notamment bistable. Elle peut être réalisée selon une exécution d'ancre flexible à force constante selon la demande EP12183559.9 du même déposant. La coopération de cette ancre 3000 avec le balancier 2 est effectuée par des cornes 3001 analogues aux extrémités 63, 64, des bras 61 et 62 de la butée anti-galop 6 décrite ci-dessus, ces cornes 3001, portées par une première partie 3100 de l'ancre 3000, sont reliées par au moins une lame flexible 5 multistable, notamment bistable, soit à une structure fixe 7, soit de préférence à une deuxième partie 3200 de l'ancre comportant des palettes 3002 de coopération avec les dents 5001 de la roue d'échappement 5000. De la même façon, ces palettes 3002 sont avantageusement construites de façon analogue à ces bras 61 et 62, et sont reliées par au moins une lame flexible 5 multistable, notamment bistable, soit à une structure fixe 7, soit de préférence à la première partie 3100 de l'ancre comportant les cornes 3001.

De façon particulièrement avantageuse, pour améliorer la marche et le rendement, l'interaction entre les cornes 3001 et le balancier 2 d'une part, ou/et entre les palettes 3002 et la roue d'échappement 5000 d'autre part, est réalisée sans contact ou avec un contact atténué, et, à cet effet, les surfaces concernées des cornes 3001 ou/et des palettes 3002 sont magnétisées ou électrisées pour coopérer en répulsion avec des surfaces antagonistes du balancier ou/et respectivement de la roue d'échappement, qui sont en matériau adéquat, ou/et avantageusement magnétisées ou respectivement électrisées de façon complémentaire. La demande PCT/EP2011/057578 au nom de SWATCH GROUP RESEARCH AND DEVELOPMENT LTD décrit une telle transmission sans contact ou à contact atténué, dont la combinaison avec un tel mécanisme flexible à lame multistable, notamment une ancre, apporte les avantages recherchés.

L'invention concerne encore un mouvement d'horlogerie 10 comportant au moins un organe régulateur à balancier 2, et qui comporte au moins un mécanisme horloger de limitation ou transmission 1000 selon l'invention. Selon le cas, le mouvement 10 comporte une structure 7 à laquelle est fixé un élément flexible bistable 5 de ce mécanisme horloger de limitation ou transmission 1000, ou bien cet élément flexible bistable 5 constitue lui-même une telle structure.

L'invention concerne encore une pièce d'horlogerie 100, notamment une montre, comportant au moins un tel mouvement 10 ou au moins un tel mécanisme horloger de limitation ou transmission 1000.

Des mécanismes équivalents basés sur des pivots classiques et des ressorts correspondant aux pivots flexibles et bistables sont considérés comme faisant partie de la présente invention qui est définie par les revendications annexées.

Les technologies utilisées pour la réalisation du dispositif ne se limitent pas à la technologie silicium mais également aux procédés « LIGA », MEMS, et autres procédés de micro-fabrication.

## Revendications

1. Mécanisme anti-galop (1) pour limiter le débattement angulaire d'un balancier d'horlogerie (2) d'un mouvement d'horlogerie (10), lequel balancier (2) comporte un arbre (3) et une cheville (4) saillante dudit arbre (3), ledit mécanisme anti-galop (1) comportant au moins un élément flexible bistable (5) qui est agencé pour être fixé, par l'intermédiaire d'éléments de liaison flexibles et élastiques que comporte ledit mécanisme (1), à un élément rigide de structure (7) dudit mouvement d'horlogerie (10), et lequel élément flexible bistable (5) est porteur d'au moins une butée anti-galop (6) qui comporte deux bras (61, 62), dont les extrémités respectives (63, 64) peuvent chacune venir en interférence avec la trajectoire de ladite cheville (4), ledit élément flexible bistable (5) étant agencé pour être fixé audit élément rigide de structure (7) par l'intermédiaire d'au moins deux lames flexibles (91 ; 92) constituant des dits éléments de liaison flexibles et élastiques, et lesquelles lames flexibles (91 ; 92) sont montées précontraintes en flambage par rapport à ladite structure (7) ou par rapport à un bâti (56) que comporte ledit élément flexible bistable (5), lesdites au moins deux lames flexibles (91,92) formant une première poutre (9) précontrainte en flambage selon un mode où ladite première poutre (9) adopte une forme en S ou en Z, un pivot (90) obligeant ladite première poutre (9) à avoir un noeud en zone médiane, ledit élément flexible bistable (5) étant réalisé par flambage sous contrainte via deux vis excentrées (94 ;95) desdites au moins deux lames flexibles (91 ; 92), une troisième poutre (93), agencée pour être fixée à ladite structure (7) ou audit bâti (56) forçant ladite première poutre (9) à se déformer dans le mode où elle adopte une forme en S ou en Z, cette troisième poutre (93) constituant ledit pivot (90).

2. Mécanisme anti-galop (1) selon la revendication 1, **caractérisé en ce que** ladite butée anti-galop (6) comporte au moins deux niveaux pour assurer le maintien desdits bras (61 ; 62) dans le plan de ladite cheville (4), à un premier niveau supérieur avec lesdits bras (61 ; 62) coopérant avec ladite cheville (4), et à un deuxième niveau inférieur avec un dard (67) coopérant avec une encoche (21) dudit balancier (2).

3. Mécanisme anti-galop (1) selon la revendication 2, **caractérisé en ce que** ledit élément flexible bistable (5) comporte des éléments flexibles (65, 66) intégrés auxdits bras (61, 62), de ladite butée (6) afin d'éviter des chocs trop importants.

4. Mécanisme anti-galop (1) selon l'une des revendications 1 à 3, **caractérisé en ce que** ledit élément flexible bistable (5) et ladite au moins une butée anti-galop (6) forment ensemble un composant monolithique.

5. Mécanisme anti-galop (1) selon l'une des revendications 1 à 4, **caractérisé en ce que** sa structure est réalisée avec un noyau central en quartz monocristallin, qui est revêtu sur ses faces supérieure et inférieure d'un dépôt avec un coefficient α inférieur au coefficient α_{x,y} du quartz, lequel est de 7,5 ppm/°C.

6. Mécanisme anti-galop (1) selon l'une des revendications 1 à 5, **caractérisé en ce que** ledit pivot (90) oblige ladite première poutre (9) à avoir un noeud en son milieu.

7. Mécanisme anti-galop (1) selon l'une des revendications 1 à 6, **caractérisé en ce que** ledit mécanisme (1) comporte un mécanisme antichoc de protection dudit élément flexible bistable (5) comportant des butées antichocs (81, 82), qui coopèrent en appui de butée avec lesdits bras (61, 62), d'au moins une dite butée anti-galop (6).

8. Mécanisme anti-galop (1) selon l'une des revendications 1 à 7, **caractérisé en ce qu'**il comporte un mécanisme antichoc de protection dudit élément flexible bistable (5) comportant une butée antichocs (83) située dans le centre de rotation (50) dudit élément flexible bistable (5).

9. Mécanisme anti-galop (1) selon l'une des revendications 1 à 8, **caractérisé en ce que** ledit élément flexible bistable (5) est réalisé monobloc avec ledit élément de structure (7).

10. Mouvement d'horlogerie (10) comportant au moins un organe régulateur à balancier (2), et qui comporte au moins un mécanisme anti-galop (1) selon l'une des revendications 1 à 9, et **caractérisé en ce que** ledit mouvement (10) comporte une structure (7) à laquelle, ou bien est fixé un dit élément flexible bistable (5) dudit mécanisme anti-galop (1) ou bien qui est constituée par ledit élément flexible bistable (5).

11. Pièce d'horlogerie (100) ou montre, comportant au moins un mouvement (10) selon la revendication précédente ou au moins un mécanisme anti-galop (1) selon l'une des revendications 1 à 9.

## Patentansprüche

1. Galoppverhinderungsmechanismus (1) zum Begrenzen des Winkelausschlags einer Uhrenunruh (2) eines Uhrwerks (10), wobei die Unruh (2) eine Welle (3) und einen von der Welle (3) vorstehenden Stift (4) umfasst, wobei der Galoppverhinderungsmechanismus (1) mindestens ein bistabiles biegsames Element (5) umfasst, das dafür ausgelegt ist, über biegsame und elastische Verbindungselemente, die der Mechanismus (1) aufweist, an einem starren Strukturelement (7) des Uhrwerks (10) befestigt zu werden, wobei das bistabile biegsame Element (5) mindestens einen Galoppverhinderungsanschlag (6) trägt, der zwei Arme (61, 62) aufweist, deren jeweilige Enden (63, 64) jeweils in die Bahn des Stifts (4) eingreifen können, wobei das bistabile biegsame Element (5) dafür ausgelegt ist, an dem starren Strukturelement (7) über mindestens zwei biegsame Plättchen (91; 92), die die biegsamen und elastischen Verbindungselemente bilden, befestigt zu werden, und wobei die biegsamen Plättchen (91; 92) in Bezug auf die Struktur (7) oder in Bezug auf einen Rahmen (56), den das bistabile biegsame Element aufweist, knickvorbelastet montiert sind, wobei die mindestens zwei biegsamen Plättchen (91, 92) einen ersten Träger (9) bilden, der gemäß einem Modus, in dem der erste Träger (9) eine S- oder Z-Form annimmt, knickvorbelastet ist, wobei ein Drehzapfen (90) den ersten Träger (9) dazu zwingt, einen Knoten in dem mittleren Bereich aufzuweisen, wobei das bistabile biegsame Plättchen (5) durch Knicken unter Belastung mittels zweier exzentrischer Schrauben (94; 95) der mindestens zwei biegsamen Plättchen (91; 92) ausgebildet ist, wobei ein dritter Träger (93), der dafür ausgelegt ist, an der Struktur (7) oder an dem Rahmen (56) befestigt zu sein, den ersten Träger (9) dazu drängt, sich in dem Modus, in dem er eine S- oder Z-Form annimmt, zu verformen, wobei dieser dritte Träger (93) den Drehzapfen (90) bildet.

2. Galoppverhinderungsmechanismus (1) nach Anspruch 1, **dadurch gekennzeichnet, dass** der Galoppverhinderungsanschlag (6) mindestens zwei Niveaus besitzt, um das Halten der Arme (61; 62) in der Ebene des Stifts (4) auf einem ersten, oberen Niveau, wo die Arme (61, 62) mit dem Stift (4) zusammenwirken, und auf einem zweiten, unteren Niveau, wo ein Sicherheitsstift (67) mit einer Kerbe (21) der Unruh (2) zusammenwirkt, zu gewährleisten.

3. Galoppverhinderungsmechanismus (1) nach Anspruch 2, **dadurch gekennzeichnet, dass** das bistabile biegsame Element (5) biegsame Elemente (65, 66) umfasst, die mit den Armen (61, 62) des Anschlags (6) einstückig ausgebildet sind, um zu große Stöße zu vermeiden.

4. Galoppverhinderungsmechanismus (1) nach einem der Ansprüche 1 bis 3, **dadurch gekennzeichnet, dass** das bistabile biegsame Element (5) und der mindestens eine Galoppverhinderungsanschlag (6) zusammen eine monolithische Komponente bilden.

5. Galoppverhinderungsmechanismus (1) nach einem der Ansprüche 1 bis 4, **dadurch gekennzeichnet, dass** seine Struktur mit einem mittleren Kern aus monokristallinem Quarz hergestellt ist, der auf seiner oberen und seiner unteren Fläche mit einem Niederschlag mit einem Koeffizienten a, der kleiner ist als der Koeffizient α_{x,y} des Quarzes, der 7,5 ppm/°C beträgt, beschichtet ist.

6. Galoppverhinderungsmechanismus (1) nach einem der Ansprüche 1 bis 5, **dadurch gekennzeichnet, dass** der Drehzapfen (90) den ersten Träger (9) dazu zwingt, einen Knoten in seiner Mitte aufzuweisen.

7. Galoppverhinderungsmechanismus (1) nach einem der Ansprüche 1 bis 6, **dadurch gekennzeichnet, dass** der Mechanismus (1) einen Stoßsicherungsmechanismus zum Schutz des bistabilen biegsamen Elements (5) umfasst, der stoßsichere Anschläge (81, 82) aufweist, die mit den Armen (61, 62) mindestens eines Galoppverhinderungsanschlags (6) abstützend anschlagend zusammenwirken.

8. Galoppverhinderungsmechanismus (1) nach einem der Ansprüche 1 bis 7, **dadurch gekennzeichnet, dass** er einen Stoßsicherungsmechanismus zum Schutz des bistabilen biegsamen Elements (5) umfasst, der einen stoßsicheren Anschlag (83) aufweist, der im Drehzentrum (50) des bistabilen biegsamen Elements (5) angeordnet ist.

9. Galoppverhinderungsmechanismus (1) nach einem der Ansprüche 1 bis 8, **dadurch gekennzeichnet, dass** das bistabile biegsame Element (5) einteilig mit dem Strukturelement (7) hergestellt ist.

10. Uhrwerk (10), das mindestens ein Regulierungsorgan (2) mit Unruh umfasst und das mindestens einen Galoppverhinderungsmechanismus (1) nach einem der Ansprüche 1 bis 9 umfasst, **dadurch gekennzeichnet, dass** das Werk (10) eine Struktur (7) aufweist, an der ein bistabiles biegsames Element (5) des Galoppverhinderungsmechanismus (1) befestigt ist oder die durch das bistabile biegsame Element (5) gebildet ist.

11. Zeitmessgerät (100) oder Uhr, umfassend mindestens ein Werk (10) nach dem vorhergehenden Anspruch oder mindestens einen Galoppverhinderungsmechanismus (1) nach einem der Ansprüche 1 bis 9.

## Claims

1. Anti-trip mechanism (1) for limiting the angular travel of a timepiece balance (2) of a timepiece movement (10), said balance (2) including a staff (3) and a pin (4) projecting from said staff (3), said anti-trip mechanism (1) including at least one flexible bistable element (5) which is arranged to be fixed, via flexible and elastic connecting members that said mechanism (1) comprises, to a rigid structural element (7) of said timepiece movement (10), and which bistable element (5) is carrying at least one anti-trip stop member (6) which includes two arms (61, 62), whose respective ends (63, 64) can each interfere with the trajectory of said pin (4) said flexible bistable element (5) being arranged to be fixed to said rigid structural element (7) via at least two flexible strips (91; 92) forming such said flexible and elastic connecting elements, and which flexible strips (91; 92) are mounted prestressed and buckled relative to said structure (7) or relative to a frame (56) comprised in said flexible bistable element (5), said at least two flexible strips (91; 92) forming a first prestressed and buckled beam (9) according to an embodiment wherein said first beam (9) adopts an S or Z shape, a pivot (90) forcing said beam (9) to have a nodal point in a middle area thereof, said flexible bistable element (5) being carried out by buckling under stress of said at least two flexible strips (91; 92) via two eccentric screws (94; 95), a third beam (93) arranged to be fixed to said structure (7) or to said frame (56) forcing said beam (9) to deform in the embodiment wherein it adopts an S or Z shape, this third beam (93) forming said pivot (90).

2. Anti-trip mechanism (1) according to claim 1, **characterized in that** said anti-trip stop member (6) includes at least two levels in order to hold said arms (61; 62) in the plane of said pin (4), on a first top level with said arms (61; 62) cooperating with said pin (4); and on a second lower level with a dart (67) cooperating with a notch (21) in said balance (2).

3. Anti-trip mechanism (1) according to claim 2, **characterized in that** said flexible bistable element (5) includes flexible elements (65, 66) integrated in said arms (61, 62), of said stop member (6) to prevent excessive shocks.

4. Anti-trip mechanism (1) according to one of claims 1 to 3, **characterized in that** said flexible bistable element (5) and said at least one anti-trip stop member (6) together form a monolithic component.

5. Anti-trip mechanism (1) according to one of claims 1 to 4, **characterized in that** the structure thereof is made with a central single crystal quartz core, the top and bottom surfaces of which are coated with a deposition having a coefficient α lower than the coefficient α_{x,y} of quartz which is 7.5ppm/°C.

6. Anti-trip mechanism (1) according to one of claims 1 to 5, **characterized in that** said pivot (90) forces said beam (9) to have a nodal point in the middle thereof.

7. Anti-trip mechanism (1) according to one of claims 1 to 6, **characterized in that** said mechanism (1) includes a protective shock absorber mechanism for said flexible bistable element (5) including shock absorber members (81, 82), which cooperate in abutment with said arms (61, 62) of at least one said anti-trip stop member (6).

8. Anti-trip mechanism (1) according to one of claims 1 to 7, **characterized in that** it includes a protective shock absorber mechanism for said flexible bistable element (5) including a shock absorber stop member (83) located in the centre of rotation (50) of said flexible bistable pivot (5).

9. Anti-trip mechanism (1) according to one of claims 1 to 8, **characterized in that** said flexible bistable element (5) is made in a single piece with said balance (7).

10. Timepiece mechanism (10) including at least one regulating member having a balance (2), and which includes at least one anti-trip mechanism (1) according to one of claims 1 to 9, and **characterized in that** said movement (10) includes a structure (7) to which one said flexible bistable element (5) of said anti-trip mechanism (1) is fixed, or which is formed by said flexible bistable element (5).

11. Timepiece (100) or watch including at least one movement (10) according to the preceding claim, or at least one anti-trip mechanism (1) according to one of claims 1 to 9.
